Europäisches Patentamt

European Patent Office

Office européen des brevets

(11) Veröffentlichungsnummer: **0 123 926**
A2

(12) # EUROPÄISCHE PATENTANMELDUNG

(21) Anmeldenummer: 84103546.2

(22) Anmeldetag: 30.03.84

(51) Int. Cl.³: **H 01 L 21/265**

(30) Priorität: 05.04.83 GB 8309125

(71) Anmelder: **Deutsche ITT Industries GmbH, Hans-Bunte-Strasse 19 Postfach 840, D-7800 Freiburg (DE)**

(84) Benannte Vertragsstaaten: **DE**

(71) Anmelder: **ITT INDUSTRIES INC., 320 Park Avenue, New York, NY 10022 (US)**

(84) Benannte Vertragsstaaten: **FR IT NL**

(43) Veröffentlichungstag der Anmeldung: 07.11.84
Patentblatt 84/45

(72) Erfinder: **Badawi, Mohammed Hani, 3 Rainsford Road, Stansted Essex (GB)**

(74) Vertreter: **Morstadt, Volker, Dipl.-Ing., c/o Deutsche ITT Industries GmbH Patent/lizenzabteilung Postfach 840 Hans-Bunte-Strasse 19, D-7800 Freiburg/Brsg. (DE)**

(84) Benannte Vertragsstaaten: **DE FR IT NL**

(54) **Verfahren zur Implantation von Ionen in ein halbleitendes Substrat.**

(57) Es wird ein Verfahren zur selektiven Implantation von Ionen in ein mittels einer Implantationsmaske (6) aus Photolack maskiertes Substrat (1), insbesondere aus halbisolierendem Galliumarsenid beschrieben, dessen Oberfläche eine metallische Oberflächenschicht (2), insbesondere aus Titan, unter der Implantationsmaske (6) schützt. Nach der Implantation wird die Implantationsmaske (6) und die Oberflächenschicht (2) entfernt und das Substrat (1) getempert. Die Oberflächenschicht (2) wirkt als Pufferschicht und verhindert die Verunreinigung der Substratoberfläche mit Photolackresten während des Tempern, wobei die Photolackreste die elektrischen Eigenschaften der Substratoberfläche beeinträchtigen könnten.

0123926

M.H. Badawi 2

Fl 1215 EP
Go/Be
20. März 1984

Verfahren zur Implantation von Ionen in ein halbleitendes Substrat

Die Erfindung betrifft ein Verfahren zur Implantation von Ionen in ein halbleitendes Substrat unter Verwendung einer Photolackmaske als Implantationsmaske mit mindestens einer Öffnung, durch die die Ionen selektiv in das Substrat implantiert werden, wonach die Photolackmaske von der Substratoberfläche entfernt wird.

Bei einem solchen Verfahren ist es möglich, daß bei den auf den Implantationsprozeß folgenden zur Herstellung von Halbleiterbauelementen erforderlichen Prozessen die Substratoberfläche mit Photolackresten verunreinigt ist. Dies ist besonders bei Substraten aus Galliumarsenid der Fall, da eine Beeinträchtigung der Oberfläche von solchen Substraten bei einer Reinigung mit herkömmlichen Mitteln nicht auszuschließen ist.

Aufgabe der Erfindung ist daher, eine Verunreinigung der Substratoberfläche durch Photolackreste bei einem Verfahren gemäß dem Oberbegriff des Anspruchs 1 auszuschließen.

Diese Aufgabe wird erfindungsgemäß bei einem solchen Verfahren gemäß dem Oberbegriff des Anspruchs 1 dadurch gelöst, daß die Photolackmaske auf einer metallischen Oberflächenschicht des Substrats ausgebildet wird und die Ionen innerhalb der Öffnung durch die Oberflächenschicht in das Substrat implantiert werden.

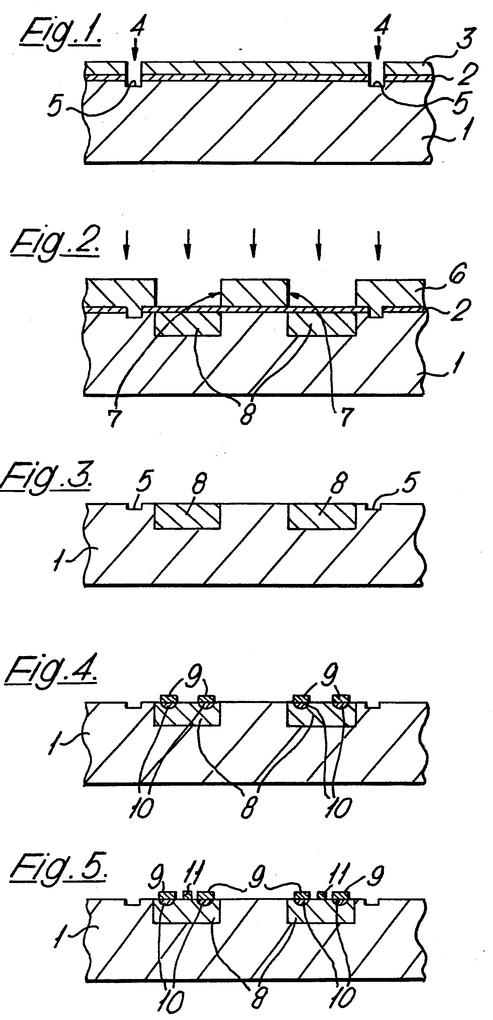

Das Verfahren der Erfindung wird im folgenden an einem Ausführungsbeispiel der Herstellung von diskreten Feldeffekttransistoren anhand der Zeichnung erläutert, deren Figuren 1 bis 5 zur Veranschaulichung der aufeinanderfolgenden Verfahrensschritte  der Herstellung dienen.

Bei der Herstellung wird von einem Substrat 1 aus halbisolierendem Galliumarsenid ausgegangen. Die  für die
Transistoren erforderlichen aktiven Bereiche werden mittels
Ionenimplantation erhalten. Auf die Oberfläche des Substrats wird, wie die Fig. 1 veranschaulicht, eine dünne
metallische  Oberflächenschicht 2 aus Titan in einer
Dicke von ca. 400 Å aufgedampft. Auf die Oberflächenschicht 2 aus Titan wird durch Aufbringen eines Tropfens
von flüssigem Photolack und folgendes Verteilen auf dem
in Rotation versetzten Substrat die Photolackschicht
3 erzeugt. In der Photolackschicht 3 werden kleine Durchbrüche 4 geöffnet, durch welche hindurch auf der Oberfläche
des Galliumarsenid-Substrats Ausrichtmarken 5 geätzt
werden. Die Schicht 3 wird entfernt und dann eine frische
Schicht 6 (Fig. 2) eines positiven Photolacks aufgebracht.
In der Photolackschicht 6 befinden sich größere Öffnungen 7,
welche eine aus Photolack bestehende Implantationsmaske
begrenzen.

Die mittels Photolack maskierte Oberfläche des Galliumarsenid-Substrats 1 wird dann dem Beschuß von Ionen,
beispielsweise mit $Si^{29}$-Ionen, ausgesetzt, wie durch
die Pfeile angedeutet wird. Diese Ionen werden somit
selektiv durch die aus Titan bestehende Oberflächenschicht 2
in Teile des Substrats implantiert, so daß im vorliegenden
Fall n-leitende Bereiche 8 entstehen.

Die Photolackschicht 6 wird mittels eines geeigneten
Lösungsmittels und die aus Titan bestehende  Oberflächenschicht durch HF-Ätzen entfernt, wodurch die selektiv
dotierte Galliumarsenid-Struktur der Fig. 3 erhalten
wird. Die Struktur wird zum Entfernen von durch die

M.H. Badawi 2                    Fl 1215 EP

Implantation hervorgerufenen Störungen einer Wärmebehandlung bei ca. 850° C unterworfen, beispielsweise einer Temperung ohne Bedeckung des Galliumarsenid-Substrats mittels einer auf die Oberfläche aufgebrachten Schutzschicht. Die Struktur wird also wärmebehandelt, wie sie in der Fig. 3 dargestellt ist.

Danach ist die Herstellung der Source- und Drain-Elektrode 9 und der Zonen 10 vorgesehen (Fig. 4). Dies kann mittels des Metallisierungs-Abhebe-Prozesses erreicht werden, bei dem auf das getemperte Substrat eine relativ dicke Photolackschicht aufgebracht wird, in der Photolackschicht entsprechend den erforderlichen Source- und Drain-Elektroden bzw. -Zonen Durchbrüche vorgesehen sind sowie die Photolackschicht und die innerhalb der Durchbrüche freigelegten Teile der Bereiche 8 mit einem dotierenden Elektrodenmetall, wie eine Gold/Germanium/Nickel-Legierung, metallbeschichtet werden. Dabei wird die Photolackschicht relativ dick im Vergleich zur Legierungsschicht ausgebildet, um ein Brechen der Legierungsschicht an den Rändern der Durchbrüche zu erzielen. Die Photolackschicht wird zusammen mit dem überflüssigen Metall abgestreift, so daß die Metallelektroden 9 auf den Bereichen 8 verbleiben. Um das Germanium aus den Metallelektroden 9 in die Bereiche 8 zu diffundieren, wird die Anordnung auf eine ausreichende Temperatur erhitzt, so daß innerhalb der Bereiche 8 Source- und Drain-Zonen 10 mit erhöhtem Dotierungsniveau erhalten werden, im vorliegendem Fall $n^+$-dotiert.

Unter Anwendung eines einfachen Metallisierungs-Abhebe-Prozesses, beispielsweise unter Verwendung eines Schottky-Metalles, wie Chrom/Gold, wird zwischen den Source- und Drain-Elektroden 9 jedes Transistors je eine Schottky-Kontakt-Gateelektrode 11 angeordnet. Schließlich wird die so hergestellte Anordnung in einzelne Bauelemente oder Schaltungen geteilt, die kontaktiert und verkapselt werden.

Die dünne Oberflächenschicht aus Titan zwischen dem Photolack und der Galliumarsenid-Oberfläche wirkt als Pufferschicht und verhütet die sonst möglicherweise erfolgende Verunreinigung der Galliumarsenid-Oberfläche, welche durch Photolackreste sich ergeben würde, falls eine derartige Pufferschicht nicht verwendet wird. Derartige Reste sind bei Anwendung des Ionenimplantations-Prozesses insbesondere dann unerwünscht, falls das Substrat der Wärmebehandlung eines Temperungprozesses nach der Ionenimplantation unterworfen wird. Nach der Ionenimplantation wäre die Oberfläche des Substrates verunreinigt und die elektrischen Eigenschaften der Halbleiterplatte ungünstig beeinflußt, falls die Substratoberfläche vom Photolack nicht durch vollständiges Entfernen gereinigt wäre. Diese Rückstände sind insbesondere bei Galliumarsenid-Substraten anzutreffen, da es nicht möglich ist, die Oberfläche eines solchen Substrats vollständig vom Photolack zu befreien, ohne die Oberfläche nachteilig anzugreifen.

Obwohl die Erfindung anhand der Herstellung von diskreten Bauelementen beschrieben wurde, ist sie auch auf die Herstellung von integrierten Schaltungen an Galliumarsenid-Substraten anwendbar. Obwohl lediglich eine Pufferschicht aus Titan vorstehend beschrieben wurde, sind auch andere metallische Oberflächenschichten verwendbar, wie Zinn, Chrom, Aluminium, Mangan, Magnesium oder Indium. Ohne Schädigung der Substratoberfläche können derartige metallische Oberflächenschichten und irgendwelche darin enthaltene Rückstände einfach und wirkungsvoll mit einem Ätzmittel aus Flußsäure oder Salzsäure entfernt werden. Obwohl das Verfahren der Erfindung anhand der Implantation von Ionen in ein Galliumarsenid-Substrat beschrieben

M.H. Badawi 2                                        Fl 1215 EP

wurde, sind Substrate aus anderen Halbleiterverbindungen oder Silizium in gleicher Weise verarbeitbar. Es ist möglich, lediglich eine gemusterte Photolackschicht für die selektive Ionenimplantation von Silizium zu verwenden, da letzteres einem sehr kräftigen Reinigungsprozeß unterworfen werden kann, um ohne schädliche Beeinträchtigung der Siliziumoberfläche sicherzustellen, daß vor dem Tempern keine Photolackreste übrig bleiben. In manchen Fällen mag es jedoch wünschenswert sein, die vorstehend beschriebene metallische, als Pufferschicht wirksame Oberflächenschicht zu verwenden.

0123926

M.H. Badawi 2

Fl 1215 EP

Go/Be
20. März 1984

## Patentansprüche

1. Verfahren zur Implantation von Ionen in ein halbleitendes Substrat unter Verwendung einer Photolackmaske als Implantationsmaske mit mindestens einer Öffnung, durch die die Ionen selektiv in das Substrat implantiert werden, wonach die Photolackmaske von dem Substrat entfernt wird, dadurch gekennzeichnet, daß die Photolackmaske (6) auf einer metallischen Oberflächenschicht (2) des Substrats (1) ausgebildet wird und die Ionen innerhalb der Öffnungen durch die Oberflächenschicht (2) in das Substrat (1) implantiert werden.

2. Verfahren nach Anspruch 1, dadurch gekennzeichnet, daß nach der Implantation der Ionen die Photolackmaske (6) und die Oberflächenschicht (2) von der Substratoberfläche entfernt werden und dann das Substrat (1) erhitzt wird, so daß die bei der Implantation entstandenen Kristallstörungen beseitigt sind.

3. Verfahren nach Anspruch 1 oder 2, gekennzeichnet durch die Verwendung eines Substrats (1) aus Galliumarsenid, auf dessen Oberfläche zunächst die metallische Oberflächenschicht und darüber die Photolackmaske aufgebracht wird.

4. Verfahren nach einem der Ansprüche 1 bis 3, gekennzeichnet durch die Verwendung einer Oberflächenschicht (2) aus Titan.

5. Anwendung eines Verfahrens nach einem der Ansprüche 1 bis 4 zum Herstellen eines Feldeffekttransistors, dadurch gekennzeichnet,

M.H. Badawi 2                        Fl 1215 EP

- daß innerhalb der Öffnung einer Photolackmaske (6) durch eine metallische Oberflächenschicht hindurch, welche auf der Oberfläche eines Substrats (1) aus halbisolierendem Galliumarsenid aufgebracht wird, zur Herstellung eines Bereichs (8) des einen Leitungstyps Ionen in das Substrat (2) implantiert werden,

- daß auf der Oberfläche des Bereichs (8) im Abstand voneinander eine Sourceelektrode und eine Drainelektrode (9) aus dotiertem Elektrodenmaterial aufgebracht werden,

- daß die Elektroden (9) in die Oberfläche unter Bildung einer diffundierten Sourcezone und einer diffundierten Drainzone (10) legiert werden, welche Zonen (10) höher als der Bereich (8) dotiert sind, und

- daß dann zwischen der Sourceelektrode und der Drainelektrode auf der Oberfläche des Bereichs (8) eine Gateelektrode (11) ausgebildet wird.

6. Verfahren nach Anspruch 5, gekennzeichnet durch die Verwendung eines Elektrodenmaterials aus einer Gold-Germanium-Nickel-Legierung zur Ausbildung der Elektroden (9).

7. Verfahren nach Anspruch 5 oder 6, dadurch gekennzeichnet, daß zwischen der Sourceelektrode und der Drainelektrode eine Gateelektrode (11) aus einem Metall ausgebildet wird, welches einen Schottky-Kontakt bildet.

8. Verfahren nach Anspruch 7, dadurch gekennzeichnet, daß das den Schottky-Kontakt bildende Metall Chrom und Gold enthält.

Fig.1.

Fig.2.

Fig.3.

Fig.4.

Fig.5.

M H RADAWI-2